# EUROPEAN PATENT APPLICATION

(11) **EP 2 595 211 A2**
(43) Date of publication of application: **22.05.2013**
(21) Application number: 11806968.1
(22) Date of filing: 24.05.2011
(51) Int. Cl.: H01L 51/56, H01L 51/52

(54) **A FLEXIBLE ELECTRONIC DEVICE, METHOD FOR MANUFACTURING SAME, AND A FLEXIBLE SUBSTRATE**

(30) Priority: 13.07.2010 KR 20100067533
(71) Applicant: Posco, Pohang Kyungsangbook-do 790-300 (KR)
(72) Inventor: LEE, Jong Lam, Pohang-si Gyeongsangbuk-do 790-751 (KR); KIM, Kee Soo, Pohang-si Gyeongsangbuk-do 790-784 (KR)
(74) Representative: Zech, Stefan Markus
(86) International application number: PCT/KR2011/003784
(87) International publication number: WO 2012/008683

(57) **Abstract**

The present invention relates to resolving issues concerning deterioration in the performance and yield of a flexible electronic device, caused by low manufacturing temperatures, high degrees of surface roughness, a high thermal expansion coefficients, and bad handling characteristics of typical flexible substrates. The method for manufacturing a flexible electronic device according to the present invention includes: forming a flexible substrate on a motherboard while physically separating the interface therebetween so that the interfacial bonding therebetween has a yield strength less than that of the flexible substrate; and forming an electronic device on the separated surface of the flexible substrate which had previously been in contact with the motherboard.

## Description

### [Technical Field]

The present invention relates to a flexible electronic device and a manufacturing method thereof, and a flexible substrate used in the flexible electronic device, and more particularly, to a method of manufacturing a flexible electronic device including a flexible substrate having low surface roughness and a low heat expansion coefficient applicable to a high temperature glass substrate process, and having superior characteristic and a new structure.

### [Background Art]

Currently, with development of information technology (IT), the importance of flexible electronic devices has increased. Thus, it is necessary to manufacture an organic light emitting display (OLED), a liquid crystal display (LCD), an electrophoretic display (EPD), a plasma display panel (PDP), a thin-film transistor (TFT), a microprocessor, a random access memory (RAM), or the like, on a flexible substrate.

Among the above-described devices, an active matrix OLED (AMOLED) has come to prominence, in that it has the greatest possibility to realize a flexible display, and thus it has become important in developing technology that may allow for high-yield manufacturing of the AMOLED while using, without any change, an existing polysilicon TFT process.

Meanwhile, in regard to the method of manufacturing an electronic device using a flexible substrate, three different methods, for example, a method of manufacturing an electronic device directly on a plastic substrate, a method of using a transfer process, and a method of manufacturing an electronic device directly on a metal substrate have been proposed.

First, in regard to the method of manufacturing an electronic device directly on a plastic substrate, Korean Patent Laid Open Publication No. 2009-0114195 discloses a method including attaching a flexible substrate made of a polymer material to a glass substrate, forming an electronic device on the flexible substrate, and separating the flexible substrate from the glass substrate, while Korean Patent Laid Open Publication No. 2006-0134934 discloses a method including coating a plastic substrate film on a glass substrate by using a spin-on method, forming an electronic device on the plastic substrate film, and separating the plastic substrate film from the glass substrate. First, in regard to the method of manufacturing an electronic device directly on a plastic substrate, Korean Patent Laid Open Publication No. 2009-0114195 discloses a method including attaching a flexible substrate made of a polymer material to a glass substrate, forming an electronic device on the flexible substrate, and separating the flexible substrate from the glass substrate, and Korean Patent Laid Open Publication No. 2006-0134934 discloses a method including coating a plastic film on a glass substrate by using a spin-on method, forming an electronic device on the plastic substrate, and separating the plastic substrate from the glass substrate.

Then, in the case of the above-mentioned published technologies, since the flexible substrate is made of a plastic or polymer material, an available process temperature is in a range of 100-350°C. However, since the manufacturing of the AMOLED, RAM, microprocessor, or the like essentially includes a thermal treatment process of the flexible substrate at a temperature of not less than 450°C, the flexible substrate has a limitation in that it may not be used for manufacturing a product such as an electronic device. Also, in the manufacturing process, a difference in thermal expansion coefficients between an inorganic semiconductor made of a material such as Si or an insulator, made of a material such as SiO₂ or SiN, and the plastic substrate may cause defects, such as cracks, delamination, and the like to thus reduce the yield.

Also, in regard to the method of using a transfer process, Korean Patent Laid Open Publication No. 2004-0097228 discloses a method including sequentially forming a separation layer, a thin film device, an adhesive layer, and an arbitrary substrate on a glass substrate, and irradiating light, such as a laser beam, onto the glass substrate to separate the transferred layer from the glass substrate.

Then, in the case of the transfer process, since a thin film device may be extremely thin, it is essentially required to perform a double transfer process in which an arbitrary substrate is adhered on a glass substrate to form a device on the arbitrary substrate and then the arbitrary substrate is again removed. The method of using the transfer process is impossible to apply to an organic electronic device, such as an OLED which has weak interfacial bonding force and is vulnerable to moisture or a solvent because the arbitrary substrate is adhered to a thin film device and then removed. Also, in the course of adhesion of the arbitrary substrate to the glass substrate and removal of the arbitrary substrate from the glass substrate, defects such as cracks, an introduction of foreign particles, or the like may be generated to thus reduce yield.

In regard to the process of using a metal substrate, Korean Patent Laid Open Publication No. 2008-0024037 discloses a method of providing a flexible electronic device having a high production yield on a metal substrate by forming a buffer layer containing a glass component on the metal substrate to lower surface roughness, Korean Patent Laid Open Publication No. 2009-0123164 discloses a method of removing a relief type pattern from a metal substrate through polishing to enhance yield, and Korean Patent Laid Open Publication No. 2008-0065210 discloses a method of creating a peel-off layer and a metal layer on a glass substrate.

Then, a thick film metal substrate, used for a flexible electronic device and being 15-150 µm thick, has a surface roughness of not less than a few hundred nm, owing to a manufacturing method thereof. For example, since a thick metal film made by a rolling has a rolling trace and a thick metal film formed on a substrate by a deposition has a surface roughness that increases in proportion to the thickness thereof and varies according to the deposition method and condition, it is difficult to manufacture a metal substrate having a low surface roughness. Therefore, in the case of a metal substrate, it is necessary to deposit a planarizing layer made of a polymer material on the metal substrate or perform a polishing process thereon in order to reduce surface roughness. Then, in the case of reducing surface roughness using a polymer material, a high temperature process may not be used with the plastic substrate. Also, the polishing process is suitable for the manufacturing of a highly priced microprocessor or RAM using a single crystalline silicon (Si) substrate, but is low in economic feasibility when applied to a relatively low priced, large-sized flexible electronic device.

### [Disclosure]

### [Technical Problem]

The present invention is intended to solve the above-mentioned drawbacks caused in the related art, and it is a main object of the present invention to provide a method of manufacturing a high performance flexible electronic device that may obtain a flexible metal substrate having a low surface roughness through a simple process without any separate polishing process, and manufacture an electronic device on the metal substrate through a high temperature process of not less than 450°C.

Another object of the present invention is to provide a method of manufacturing a high performance flexible electronic device applicable to a process performed at a temperature that is the same as or higher than a processing temperature for a glass substrate.

Another object of the present invention is to provide a flexible metal substrate for an electronic device having a low heat expansion coefficient such that defects, such as cracks, delaminations, and the like are not generated due to a difference in a heat expansion coefficient between a substrate and a device manufactured thereon.

### [Technical Solution]

As a means for solving the above-mentioned issues, the present invention provides a method of manufacturing a flexible electronic device including: forming a flexible substrate on a motherboard; separating the flexible substrate from the motherboard; and forming an electronic device on a surface of the flexible substrate separated from the motherboard.

(2) Also, the present invention provides a method of manufacturing a flexible electronic device including: forming a flexible substrate on a motherboard; adhering an arbitrary substrate having an adhesive layer on one surface thereof on the flexible substrate by using the adhesive layer; separating the flexible substrate having the arbitrary substrate adhered thereon from the motherboard; and forming an electronic device on a surface of the flexible substrate separated from the motherboard.

In the case of the manufacturing method of (1) or (2), since the separated surface of the flexible substrate has an almost similar surface state to the surface state of the motherboard by forming the flexible substrate made of a metal on the motherboard having a very low degree of surface roughness and repetitively available, and then separating the flexible substrate from the motherboard, there is no need to use a high cost polishing process or a polymer coating process, allowing a high temperature process to be unavailable, so that a high performance flexible electronic device may be fabricated at a inexpensive cost.

Also, since the manufacturing method of (2) uses the arbitrary substrate, it is possible to use the process conditions and facilities as they are, employed in the related art glass substrate process applicable to a high temperature process of not less than 450°C.

(3) The manufacturing method of (1) or (2) may further include forming a delamination layer on the motherboard, wherein the flexible substrate may be separated from the motherboard by using the delamination layer.

While the delamination layer is further provided between the flexible substrate and the motherboard, since the delamination layer has a similar surface roughness to the motherboard, the surface roughness of the separated surface of the flexible substrate may be also maintained at a similar level to the motherboard. Since the addition of the delamination layer may lower the interfacial bonding force to separate the flexible substrate even when the yield strength of the flexible substrate is low, the flexible substrate may be prevented from being damaged during the separation thereof. Also, the delamination layer may be formed in a multilayered composite layer made of several materials when required.

(4) In the manufacturing method of (1) or (2), the flexible substrate and the motherboard may be configured such that the interfacial bonding force therebetween is lower than the yield strength of the flexible substrate and the flexible substrate is separated from the motherboard via a physical force.

(5) In the manufacturing method of (3), the delamination layer and the flexible substrate may be configured such that the interfacial bonding force therebetween is lower than the yield strength of the flexible substrate and the flexible substrate is separated from the motherboard via physical force.

As in (4) or (5), when the yield strength of the flexible substrate is higher than the interfacial bonding force between the motherboard (or delamination layer) and the flexible substrate, the flexible substrate may be separated from the motherboard without any deformation of the flexible substrate.

(6) In the manufacturing method of (1) or (2), it is preferable that the surface roughness of the motherboard on which the flexible substrate is formed is 0<Rms<100nm, and 0<Rp-v<1000nm as observed in a scan range of 10µm×10µm by an atomic force microscope (AFM).

(7) In the manufacturing method of (3), it is preferable that the surface roughness of the delamination layer on which the flexible substrate is formed is 0<Rms<100 nm and 0<Rp-v<1000 nm as observed in a scan range of 10µm×10µm by an atomic force microscope (AFM).

In the manufacturing method of (6) or (7), the reason the surface roughness of the motherboard or the delamination layer is maintained in the above-mentioned range is because the surface roughness of the separated surface of the flexible substrate rises, and thus, if an electronic device is formed without a subsequent polishing, it is difficult to materialize a high quality electronic device.

(8) In the manufacturing method of (1), it is preferable that the flexible substrate is 5-500µm thick. If the flexible substrate is formed to a thickness of less than 5µm, the flexible substrate is so thin that it may be damaged when a physical force is applied thereto, and if the flexible substrate is formed to a thickness of more than 5µm, the flexible substrate is so thick that the flexibility of the flexible substrate may be reduced. Therefore, it is most preferable that the flexible substrate on the motherboard be formed to be within the above-mentioned thickness range.

(9) In the manufacturing method of (2), it is preferable that the flexible substrate including the arbitrary substrate has a thickness range of 5-500µm, and the reason for which the thickness range of the flexible substrate including the arbitrary substrate is limited to the above-mentioned range is the same as that that mentioned above in relation to the flexible substrate.

(10) In the manufacturing method of (1) or (2), a planarizing layer may be further formed between the flexible substrate and the motherboard.

(11) In the manufacturing method of (3), a planarizing layer may be further formed on one surface or both surfaces of the delamination layer.

Since the planarizing layer used in the manufacturing method of (10) or (11) is applied not to the flexible substrate but to the motherboard, a polymer material may be used without consideration of a process temperature for manufacturing the electronic device, and the planarizing layer helps in the maintenance of the surface roughness of the flexible substrate at a low level. The planarizing layer may be used without particular limitation if it is made of a material able to maintain the surface roughness at a low level, and it is preferable that the planarizing layer is made of one or more polymer selected from the group consisting of polyimide (PI) or a copolymer containing PI, a polyacrylic acid or a copolymer containing the polyacrylic acid, polystyrene or a copolymer containing the polystyrene, polysulfate or a copolymer containing the polysulfate, a polyamic acid or a copolymer containing the polyamic acid, polyamine or a copolymer containing the polyamine, polyvinylalcohol (PVA), polyallyamine, and a polyacrylic acid.

(12) In the manufacturing method of (2), a separation layer may be formed between the arbitrary substrate and the adhesive layer so as to make it easy to separate the arbitrary substrate.

(13) In the manufacturing method of (1) or (2), the motherboard may be made of a glass material, a metal material, or a polymer material.

Among the above-mentioned materials, the glass material may include one more selected from the group consisting of silicate glass, borosilicate glass, phosphate glass, molten silica glass, quartz, sapphire, E2K, and vicor.

Also, the metal material may include one or more metal or alloys thereof selected from the group consisting of Fe, Ag, Au, Cu, Cr, W, Al, W, Mo, Zn, Ni, Pt, Pd, Co, In. Mn, Si, Ta, Ti, Sn, Zn, Pb, V, Ru, Ir, Zr, Rh, Mg, Invar, and steel use stainless (SUS).

The polymer material may include one or more polymer compound selected from the group consisting of polyimide (PI) or a copolymer containing PI, a polyacrylic acid or a copolymer containing the polyacrylic acid, polystyrene or a copolymer containing the polystyrene, polysulfate or a copolymer containing the polysulfate, a polyamic acid or a copolymer containing the polyamic acid, polyamine or a copolymer containing the polyamine, polyvinylalcohol (PVA), polyallyamine, and a polyacrylic acid.

(14) In the manufacturing method of (1) or (2), the flexible substrate may have a multilayered structure including layers formed of two or more different materials.

(15) Also, in the manufacturing method of (2), it is preferable that the adhesive layer include one or more polymer adhesive selected from the group consisting of epoxy, silicon, and an acrylic resin, contains one or more material selected from the group consisting of SiO₂, MgO, ZrO₂, Al₂O₃, Ni, Al, and mica, and is usable at a temperature of not less than 450°C.

(16) In the manufacturing method of (1) or (2), the motherboard may have a flat plate shape, a semi-cylindrical shape, or a cylindrical shape, and the cylindrical shape of the motherboard is suitable for mass production, compared with other shapes, since it may use a roll to roll process.

(17) In the manufacturing method of (1) or (2), the flexible substrate may be formed by a casting method, an electron beam evaporation method, a thermal evaporation method, a sputtering method, a chemical vapor deposition method, or an electroplating method.

(18) In the manufacturing method of (1) or (2), the electronic device may be one or more selected from the group consisting of an organic light emitting display (OLED), a liquid crystal display (LCD), an electrophoretic display (EPD), a plasma display panel (PDP), a thin-film transistor (TFT), a microprocessor, and a random access memory (RAM).

(19) Also, as means to solve the above-mentioned another object, the present invention provides a flexible electronic device manufactured by the above-described method.

(20) As a means to solve the above-mentioned another object, the present invention provides a flexible substrate characterized in that a flexible substrate is formed on a substrate of which surface roughness is controlled to a value of not more than a predetermined value, the flexible substrate is separated by a physical force, and then a separated surface of the flexible substrate is used as a surface for forming an electronic device.

(21) In the flexible substrate of (20), the flexible substrate is characterized in that the surface roughness of the separated surface is 0<Rms<100 nm and 0<Rp-v<1000 nm without any additional polishing process as observed in a scan range of 10µm×10µm by using an atomic force microscope (AFM).

(22) In the flexible substrate of (20) or (21), it is preferable that the flexible substrate is made of a metal material, and the metal material is an INVAR alloy or stainless steel. In particular, since the INVAR alloy may control the heat expansion coefficient thereof to a level similar to that of an inorganic semiconductor, such as Si or an insulator, such as SiO₂, SiN, or the like, there is no need to change a process condition, such as a temperature rise rate, a temperature drop rate, or the like, and is also advantageous in decreasing generation of cracks.

(23) In the flexible substrate of (20) or (21), it is preferable that the flexible substrate has a thickness range of 5-500µm, and the reason is the same as that described above.

### [Advantageous Effects]

Since the method of manufacturing an electronic device, the flexible electronic device, and the flexible substrate according to the present invention may obtain the following effects, it is expected that they may greatly contribute to the manufacturing of a high performance flexible electronic device at low cost.

First, by forming an electronic device on the separated surface having almost the same degree of surface roughness as the motherboard, the drawback in relation to the surface roughness of a flexible substrate, especially a metal flexible substrate, that is an unsolved object in the manufacturing method of a flexible electronic device according to the related art, may be easily solved.

Secondly, since it is possible to maintain the surface roughness of the flexible substrate at a very low level, a polymer-based planarizing layer having a processing temperature of not more than 350°C may be unnecessary to save process time and cost, and a high performance electronic device, such as a polysilicon TFT may be advantageously made via a high temperature process performed at a temperature of not less than 450°C.

Thirdly, in the manufacturing of a flexible substrate, a high price polishing process becomes unnecessary, and the problem of a low yield caused by a high defect density may be solved to thus improve the economic feasibility.

Fourthly, since the heat expansion coefficient of the flexible substrate may be lowered to a level similar to that of an inorganic semiconductor such as Si or an insulator such as SiO₂, SiN, or the like by using a flexible substrate made of an INVAR alloy according to the present invention, there is no need to change processing conditions, such as a temperature rise rate, a temperature drop rate, or the like, and is also advantageous in decreasing generation of a crack.

Fifthly, according to the method of manufacturing an electronic device by using an arbitrary substrate supporting a flexible substrate in an aspect of the present invention, the existing process conditions and facilities may be used as they are, without drawbacks, such as a bending, a return, and an alignment of the flexible substrate, so that easy handling is possible.

Sixthly, in the delamination method, since the yield strength of the flexible substrate is higher than the interfacial bonding force in the delaminated interface, the flexible substrate is not damaged during the delamination, thereby advantageously enhancing the production yield.

### [Description of Drawings]

Fig. 1 illustrates a method of manufacturing a flexible electronic device according to a first embodiment of the present invention.

Fig. 2 illustrates a method of manufacturing a flexible electronic device according to a second embodiment of the present invention, and a shape of delamination when a delamination layer is formed between a flexible substrate and a motherboard.

Fig. 3 illustrates a method of manufacturing a flexible electronic device according to a third embodiment of the present invention.

Fig. 4 illustrates measurement results of interfacial bonding force between a motherboard and a flexible substrate and between a delamination layer and the flexible substrate.

Fig. 5 illustrates measurement results of surface roughness in upper and lower surfaces of each of a motherboard and a flexible substrate and results of delamination when the thickness of the flexible substrate is thin in the method of manufacturing a flexible electronic device according to the first embodiment of the present invention.

Fig. 6 illustrates measurement results of surface roughness in upper and lower surfaces of each of a motherboard and a flexible substrate in the method of manufacturing a flexible electronic device according to the second embodiment of the present invention.

Fig. 7 illustrates a method of manufacturing a flexible electronic device according to a third embodiment of the present invention.

Fig. 8 illustrates optical and electrical characteristics of the flexible electronic device according to the third embodiment of the present invention and of an electronic device formed on a glass substrate.

### [Best Mode]

Hereinafter, preferred embodiments of the present invention will be described in detail with reference to the accompanying drawings.

Also, terms or words used in the description and claims should be not construed as typical and dictionary definitions but should be construed as having meanings and being concepts corresponding to the technical spirit of the present invention based on a principle in which inventors are best able to properly define concepts of such terms to explain their invention by a best mode.

Therefore, the embodiments described in the specification and the constructions illustrated in the drawings are only preferred embodiments and should not be construed as embracing all of the technical spirit of the present invention. It shall be understood by those skilled in the art that various equivalents and modified examples able to replace those embodiments and drawings may be made at the time of filing the present invention and the scope of the present invention should not be construed as being limited to the following embodiments.

Rather, these embodiments of the present invention are provided so as to more completely explain the present invention to those skilled in the art, and in the drawings, the dimensions of layers or regions may be exaggerated for clarity.

[Example 1]

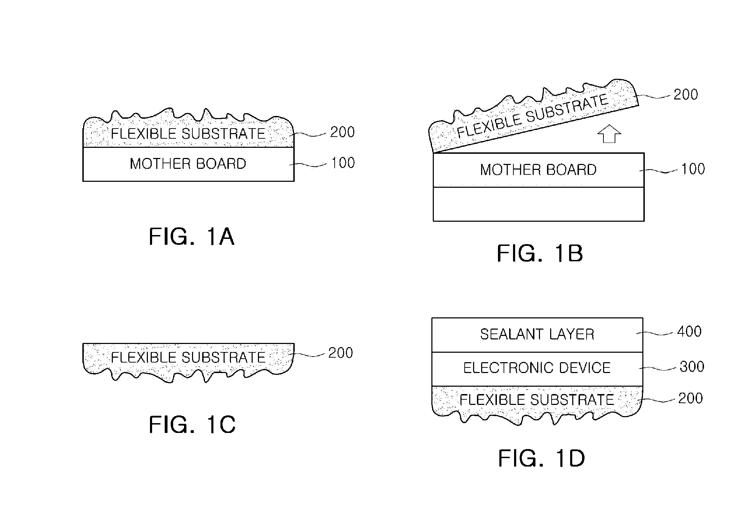

Fig. 1 schematically illustrates a method of manufacturing a flexible electronic device according to a first embodiment of the present invention. As illustrated in Fig. 1,a method of manufacturing a flexible electronic device according to a first embodiment of the present invention largely includes forming a flexible substrate 200 on a motherboard 100 (Fig. 1A), separating the flexible substrate 200 from the motherboard (Fig. 1B) to manufacture a flexible substrate (Fig. 1C), and forming an electronic device 300 and a sealant layer 400 on a separated surface of the separated flexible substrate 200 (Fig. 1D).

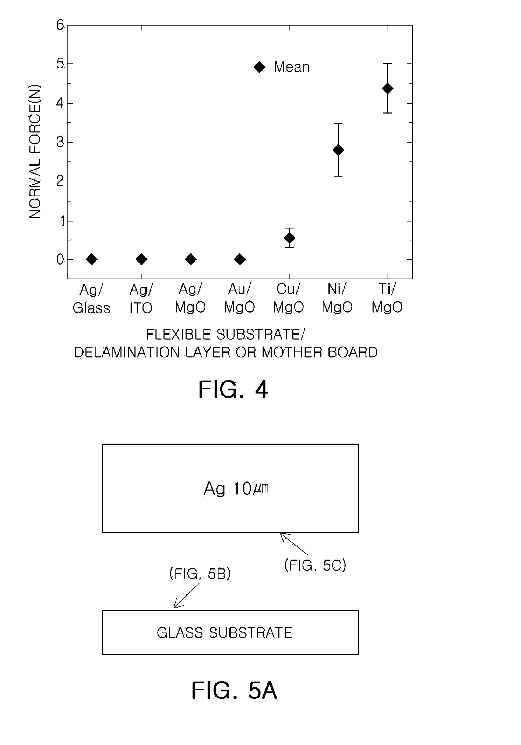

As a prior stage for manufacturing the flexible substrate 200, the inventors of the present invention investigated interfacial bonding force between the motherboard 100 and the flexible substrate 200 formed on the motherboard 100, and between a delamination layer 500 formed on the motherboard 100 and the flexible substrate 200, and investigated results are illustrated in Fig. 4.

The investigation results of interfacial bonding force illustrated in Fig. 4 were obtained by performing a scratch test. The scratch test is a method of estimating adhesive force from a critical load value of when a thin film is peeled off by contacting a round tip of a stylus with a surface of the thin film formed on a substrate and then moving the substrate while increasing a load applied to the thin film. While it is difficult to quantitatively investigate and interpret a relationship between the critical load and an actual adhesive force of the thin film, use of the same critical load and the same stylus is an easy and reproducible method for measuring a relative bonding force between thin films. In the test, the thickness of the delamination layer was 10 nm, and the thickness of the metal layer was 100 nm. An initially applied stress was 0.03 N, a finally applied stress was 7.5 N, an applied speed was 5 N/min, a moving speed of the stylus was 10 mm/min, and a length was 15 mm. Since when the metal layer is so thick, a mechanical property of the metal layer is more reflected than the interfacial bonding force, the test was performed with a metal layer which was thinner than the flexible substrate.

In the experimental condition of Fig. 4, 3M sticky tape has a bonding force ranging from about 5N to about 8N as a reference value.

As confirmed from Fig. 4, when an Ag substrate was used as the flexible substrate, the interfacial bonding force was less than the measurement range of the scratch test regardless of the material of the motherboard or the delamination layer Also, in case that a delamination layer (made of ITO or MgO) was formed on a glass substrate and then an Au, Cu, Ni or Ti substrate was formed as the flexible substrate, and in case that an Au layer was deposited on an MgO layer, the interfacial bonding force was less than the measurement range of the scratch test as measured. Also, in case that a glass substrate was used as the motherboard, in case that an MgO layer was used as the delamination layer, and in case that a Cu, Ni, or Ti substrate was used as the flexible substrate, the interfacial bonding force was increased to 0.56 N, 2.81N, 4.37 N, respectively, but in all cases, the interfacial bonding force was low to such a degree that the flexible substrate might be physically separated from the motherboard/the delamination layer without any damage, and an actually separated surface exhibited a similar surface roughness to the motherboard.

In the first example of the present invention, a glass substrate was used as the motherboard 100, and then an Ag thick layer (i.e., flexible substrate) was formed on the glass substrate to a thickness of 10µm by a thermal evaporation, and was separated from the glass substrate by hand in a physical separating method.

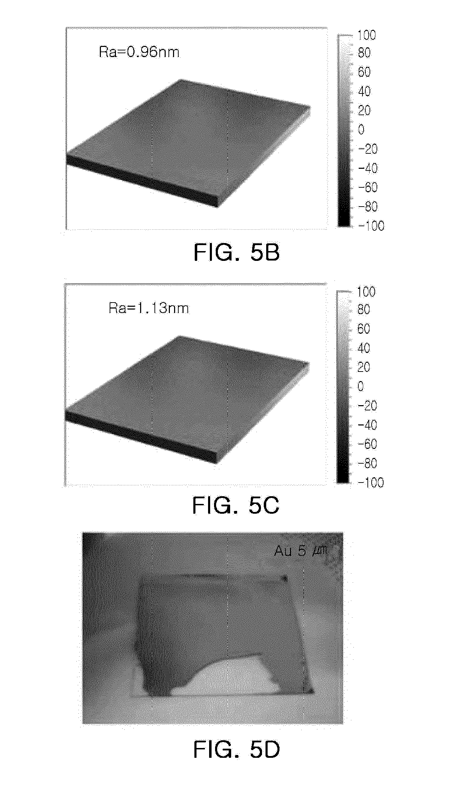

Thereafter, the surface roughness of each of these layers was evaluated with a 3D profiler. As illustrated in Fig. 5, the surface roughness of the glass substrate was 0.96 nm (Fig. 5B), and the surface roughness of the separated surface of the Ag flexible substrate was 1.13 nm (Fig. 5C), which was so low that it was an almost similar to that of the glass substrate.

Next, an OLED was formed on the separated surface of the separated flexible substrate 200. The flexible OLED was manufactured by a method including forming a photoresist on the Ag flexible substrate, exposing the photoresist to light by using the Ag flexible substrate as a reflective electrode to form a photoresist pattern, forming a hole injection layer of CuO to a thickness of 1 nm on the photoresist pattern, forming a hole transport layer of a-NPD on the hole injection layer to a thickness of 70 nm , forming a light emitting layer of Alq3 on the hole transport layer to a thickness of 40 nm, forming a hole blocking layer of BCP on the light emitting layer to a thickness of 5 nm, forming an electron transport layer of Alq3 on the hole blocking layer to a thickness of 20 nm, and forming a transparent electrode of Al on the electron transport layer to a thickness of 10 nm.

In Example 1 of the present invention, it was confirmed that although there is a difference according to the interfacial bonding force of a layer to be delaminated, deposition condition, delaminating method, and type of material constituting the flexible substrate, the thickness of the flexible substrate should be preferably 5µm or more, more preferably 10µm or more so as to separate the flexible substrate from the motherboard without any damage. As seen from Fig. 5d, when the Ag flexible substrate was 5µm thick, the Al flexible substrate was torn during the lamination, and was difficult to handle.

### [Modes for carrying out the invention]

[Example 2]

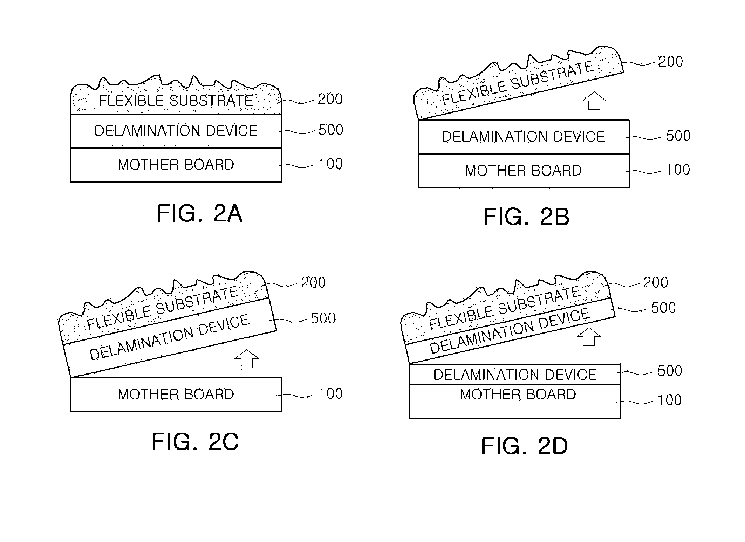

As illustrated in Fig. 2A, unlike Example 1, in Example 2, a flexible substrate 200 was manufactured through a method of forming a delamination layer 500 between a motherboard 100 and the flexible substrate 200. When the delamination layer 500 is formed thus, the flexible substrate 200 may be separated from an interface of the flexible substrate 200 (Fig. 2B), from an interface between the motherboard 100 and the delamination layer 500 (Fig. 2B), or from an inner surface of the delamination layer 500 (Fig. 2D). At this time, the case of Fig. 2B does not need a subsequent process, but the cases of Figs. 2C and 2D may further include removing the delamination layer 500.

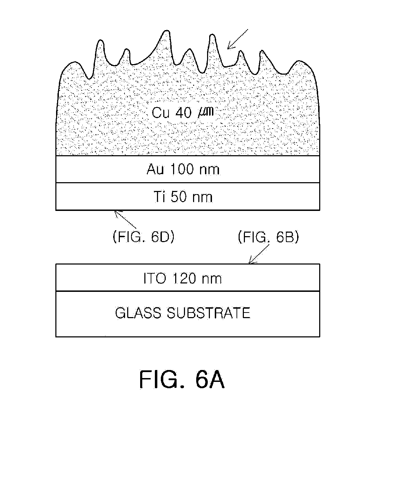

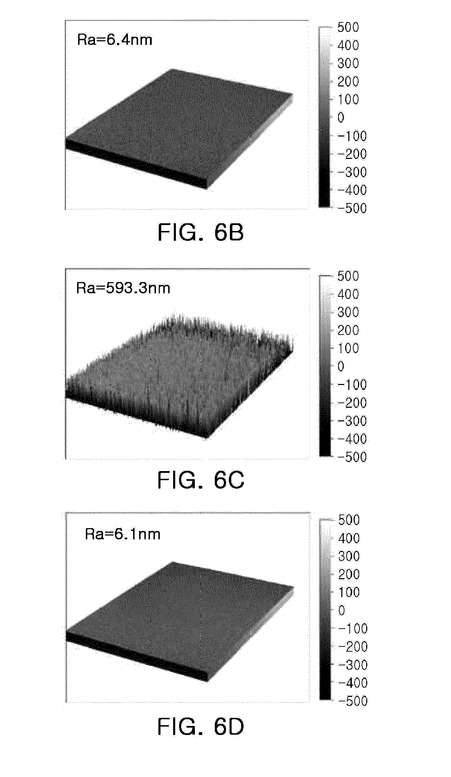

In Example 2 of the present invention, an ITO layer was formed as the delamination layer to a thickness of 120 nm on a glass substrate, a flexible substrate having a Ti/Au/Cu multilayered structure was formed on the ITO layer by respectively forming a Ti underlayer for the formation of a Cu layer and an Au seed layer on the ITO layer to 50 nm and 100 nm and then forming a Cu layer to 40 µm, and then the flexible Ti/Au/Cu substrate was separated by physically detaching the same from the glass substrate/ITO layer (Fig. 6A). Surface roughness of each of a separated surface of the flexible Ti/Au/Cu substrate and a separated surface of the glass substrate was observed in a scan range of 10µm□10µm using a 3D profiler, the surface roughness of each of the separated surface of the flexible Ti/Au/Cu substrate and the separated surface of the glass substrate was 6.4 nm (Fig. 6B). Also, the surface roughness of the flexible substrate formed on the glass substrate prior to being separated was high (593.2 nm), but it was confirmed after being separated from the glass substrate that the surface roughness of the separated surface of the separated flexible substrate was 6.1 nm, which was very low and similar to that of the glass substrate, i.e., motherboard.

[Example 3]

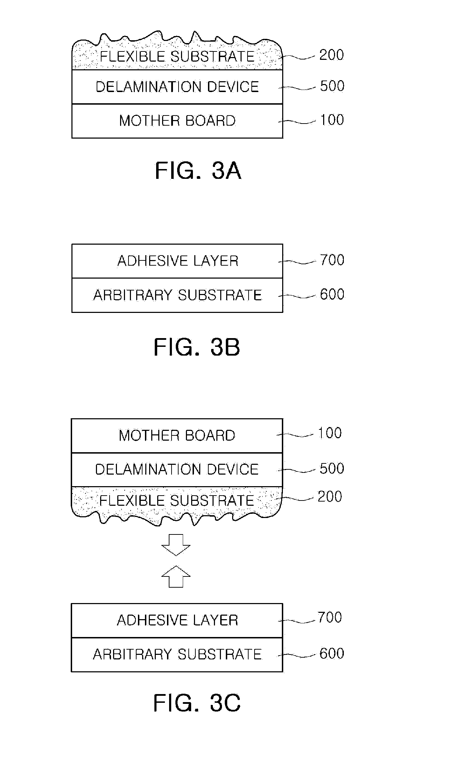

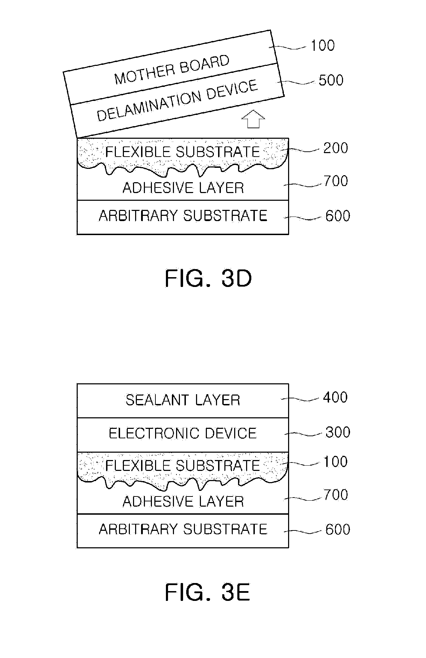

Fig. 3 schematically illustrates a method of manufacturing a flexible electronic device according to a third embodiment of the present invention. As illustrated in Fig. 3, in a method of manufacturing a flexible electronic device according to a third embodiment of the present invention, a flexible substrate 200 was formed on a motherboard 100 with a delamination layer 500 interposed therebetween (Fig. 3A), and an arbitrary substrate 600 was adhered on the flexible substrate 200 with an adhesive layer 700 interposed therebetween (Fig. 3C). Thereafter, the motherboard 100 formed on the flexible substrate 200 was separated using the delamination layer 500 (Fig. 3D), and an electronic device 300 and a sealant layer 400 were formed on a separated surface of the flexible substrate 200 to manufacture a flexible electronic device (Fig. 3E).

That is, the method in the third embodiment is different from that in the first embodiment in that it uses the arbitrary substrate 600 for handling the flexible substrate 200. Meanwhile, the adhered arbitrary substrate 600 may be used in an adhered state or a separated state according to use thereof. If the separation of the arbitrary substrate is required, it is preferable to further form a separation layer between the adhesive layer 700 and the arbitrary substrate 600.

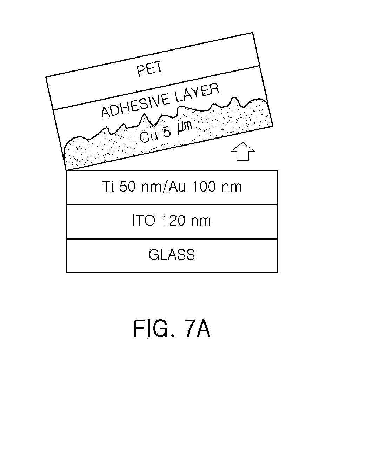

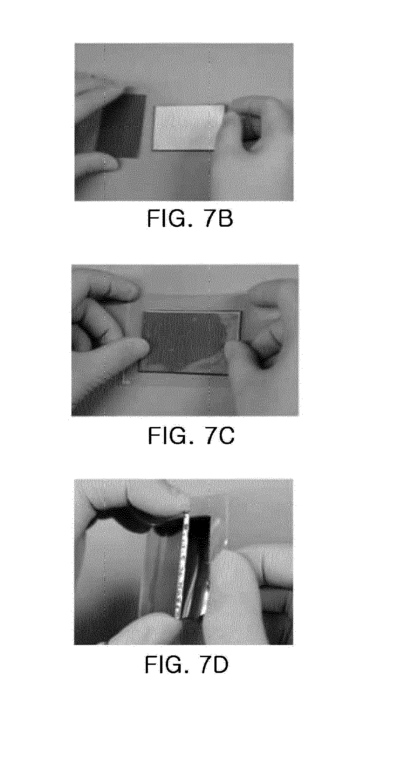

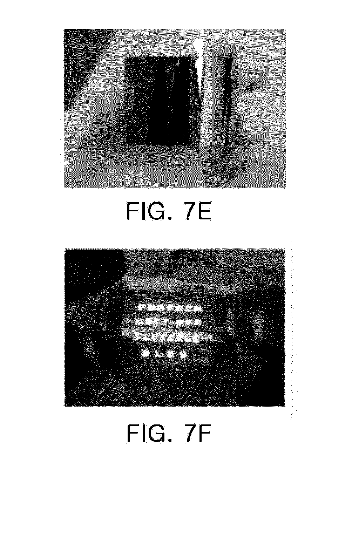

Specifically, as illustrated in Figs. 7A and 7B, an ITO layer was formed as the delamination layer on a mother glass substrate 100 to 120 nm in order to lower an interfacial bonding force between the mother glass substrate 100 and the flexible substrate, and then a flexible Ti/Au/Cu substrate was formed on the ITO layer by respectively forming a Ti underlayer and an Au seed layer to 50 nm and 100 nm and forming a Cu layer on the Au seed layer to 5 µm. To reinforce the flexible Cu substrate having a thin thickness of 5 µm, a PET arbitrary substrate having an adhesive layer formed on one surface thereof was adhered on the flexible substrate. As illustrated in Fig. 7D, the flexible Ti/Au/Cu substrate including the arbitrary substrate was separated from the glass substrate/ITO layer by physically detaching the same without using much force. As illustrated in Fig. 7E, the flexible substrate 200 having a separated surface having a very low degree of surface roughness was obtained. As illustrated in Fig. 7F, an OLED was formed on the separated surface of the flexible substrate. The flexible OLED was manufactured by a method including forming a photoresist on the Ag flexible substrate having the thickness of 100 nm, exposing the photoresist to light by using the Ag flexible substrate as a reflective electrode to form a photoresist pattern, forming a hole injection layer of CuO to a thickness of 1 nm on the photoresist pattern, forming a hole transport layer of a-NPD on the hole injection layer to a thickness of 70 nm, forming a light emitting layer of Alq3 on the hole transport layer to a thickness of 40 nm, forming a hole blocking layer of BCP on the light emitting layer to a thickness of 5 nm, forming an electron transport layer of Alq3 on the hole blocking layer to a thickness of 20 nm, and forming a transparent electrode of Al on the electron transport layer to a thickness of 10 nm.

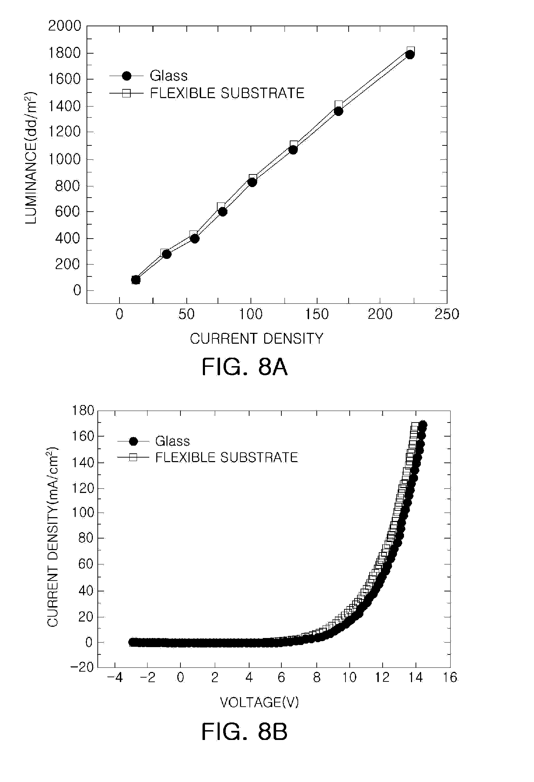

Fig. 8 illustrates evaluation results of optical and electrical characteristics of flexible OLEDs manufactured by the same process as that in Example 3 and having a light emitting area of 3mm×3mm. As illustrated in Fig. 8, when OLEDs were formed on the flexible substrate manufactured according to Example 3 using the glass substrate as the motherboard, results of current-light amount and voltage-current characteristics

## Claims

1. A method of manufacturing a flexible electronic device comprising: forming a flexible substrate on a motherboard; separating the flexible substrate from the motherboard; and forming an electronic device on a surface of the flexible substrate separated from the motherboard.

2. A method of manufacturing a flexible electronic device comprising: forming a flexible substrate on a motherboard; adhering an arbitrary substrate having an adhesive layer on one surface thereof on the flexible substrate by using the adhesive layer; separating the flexible substrate having the arbitrary substrate adhered thereon from the motherboard; and forming an electronic device on a surface of the flexible substrate separated from the motherboard.

3. The method of claim 1 or 2, **characterized by** further comprising forming a delamination layer on the motherboard, wherein the flexible substrate is separated from the motherboard by using the delamination layer.

4. The method of claim 1 or 2, **characterized in that** the flexible substrate and the motherboard are configured such that an interfacial bonding force therebetween is lower than the yield strength of the flexible substrate and the flexible substrate is separated from the motherboard via a physical force.

5. The method of claim 3, **characterized in that** the delamination layer and the flexible substrate are configured such that the interfacial bonding force therebetween is lower than the yield strength of the flexible substrate and the flexible substrate is separated from the motherboard via a physical force.

6. The method of claim 1 or 2, **characterized in that** the surface roughness of the delamination layer on which the flexible substrate is formed is 0<Rms<100 nm and 0<Rp-v<1000 nm as observed in a scan range of 10µm×10µm by an atomic force microscope (AFM).

7. The method of claim 3, **characterized in that** the surface roughness of the delamination layer on which the flexible substrate is formed is 0<Rms<100 nm and 0<Rp-v<1000 nm as observed in a scan range of 10µm×10µm by an atomic force microscope (AFM).

8. The method of claim 1, **characterized in that** the flexible substrate is 5-500µm thick.

9. The method of claim 2, **characterized in that** the flexible substrate including the arbitrary substrate is 5-500µm thick.

10. The method of claim 1 or 2, **characterized by** further comprising forming a planarizing layer between the flexible substrate and the motherboard.

11. The method of claim 3, **characterized by** further comprising forming a planarizing layer on one surface or both surfaces of the delamination layer.

12. The method of claim 2, **characterized in that** the delamination layer is formed between the arbitrary substrate and the adhesive layer.

13. The method of claim 1 or 2, **characterized in that** the motherboard is made of a glass, a metal, or a polymer material.

14. The method of claim 1 or 2, **characterized in that** the flexible substrate has a multilayered structure including layers formed of two or more different materials

15. The method of claim 1, **characterized in that** the flexible substrate is made of one or more metal selected from the group consisting of Fe, Ag, Au, Cu, Cr, W, Al, W, Mo, Zn, Ni, Pt, Pd, Co, In. Mn, Si, Ta, Ti, Sn, Zn, Pb, V, Ru, Ir, Zr, Rh, Mg, and Invar.

16. The method of claim 1 or 2, **characterized in that** the flexible substrate is formed by a casting method, an electron beam evaporation method, a thermal evaporation method, a sputtering method, a chemical vapor deposition method, or an electroplating method.

17. The method of claim 1 or 2, **characterized in that** the electronic device is one or more selected from the group consisting of an organic light emitting display (OLED), a liquid crystal display (LCD), an electrophoretic display (EPD), a plasma display panel (PDP), a thin-film transistor (TFT), a microprocessor, and a random access memory (RAM).

18. The method of claim 1 or 2, **characterized in that** the motherboard has a flat plate shape, a semi-cylindrical shape, or a cylindrical shape.

19. A flexible electronic device manufactured by the method of claim 1 or 2.

20. A flexible substrate **characterized in that** a flexible substrate is formed on a substrate of which surface roughness is controlled to a value of not more than a predetermined value, the flexible substrate is separated by a physical force, and then a separated surface of the flexible substrate is used as a surface for forming an electronic device.

21. The flexible substrate of claim 20, **characterized in that** the surface roughness of the separated surface is 0<Rms<100 nm and 0<Rp-v<1000 nm without any additional polishing process as observed in a scan range of 10µm×10µm by using an atomic force microscope (AFM).

22. The flexible substrate of claim 20 or 21, **characterized in that** the flexible substrate is made of a metal.

23. The flexible substrate of claim 22, **characterized in that** the metal is an Invar alloy or a stainless steel.

24. The method of claim 20 or 21, **characterized in that** the flexible substrate is 5-500µm thick.
